# FASCICULE DE BREVET EUROPEEN

(11) **EP 3 331 030 B1**
(45) Date de publication et mention de la délivrance du brevet: **15.05.2019**
(21) Numéro de dépôt: 17201476.3
(22) Date de dépôt: 14.11.2017
(51) Int. Cl.: H01L 31/0216, H01L 31/18

(54) **STRUCTURE ET PROCEDE DE PASSIVATION**
PASSIVIERUNGSSTRUKTUR UND -PROZESS
PASSIVATION STRUCTURE AND PROCESS

(30) Priorité: 30.11.2016 FR 1661730
(43) Date de publication de la demande: 06.06.2018
(73) Titulaire: Commissariat à l'Energie Atomique et aux Energies Alternatives, 75015 Paris (FR)
(72) Inventeur: CABAL, Raphaël, 73000 CHAMBERY (FR)
(74) Mandataire: Talbot, Alexandre

(56) Documents cités:
- WO-A1-2015/076678
- WO-A1-2016/174351
- WO-A1-2016/174352
- CN-A- 103 346 210
- DE-A1-102013 211 746

## Description

### Domaine technique

L'invention se rapporte au domaine technique de la passivation d'une surface d'un substrat à base de silicium cristallin.

L'invention trouve notamment son application dans la fabrication de cellules photovoltaïques.

### Etat de la technique antérieure

Il est connu de l'état de la technique d'utiliser une couche d'alumine pour passiver une surface d'un substrat à base de silicium cristallin. La couche d'alumine présente généralement une épaisseur supérieure ou égale à 20 nm, et est stable lorsqu'elle est soumise à un traitement thermique à une température comprise entre 300°C et 600°C pendant quelques minutes. En revanche, la couche d'alumine ne peut supporter de hautes températures très longtemps sans se dégrader. Par exemple, un traitement thermique supérieur à 800°C ne doit pas excéder quelques secondes. Le document WO 2016/174351 A1 décrit un procédé de passivation de cellule solaire connu dans l'état de la technique.

Une couche d'alumine est très efficace pour passiver une surface d'un substrat à base de silicium cristallin en termes de réduction de la densité de défauts d'interface (Dit pour « *Interface Trap Level Density* » exprimée en cm⁻²) mais est difficilement utilisable en l'état en combinaison avec un traitement thermique du bore (lié à une implantation ou une diffusion) qui implique des températures comprises entre 850°C et 1050°C.

### Exposé de l'invention

L'invention vise à remédier en tout ou partie aux inconvénients précités. A cet effet, l'invention a pour objet une structure pour passiver une surface d'un substrat à base de silicium cristallin, comportant :
- une première couche, à base d'alumine, destinée à être formée à la surface du substrat, et présentant une épaisseur strictement inférieure à 20 nm ;
- une deuxième couche, à base d'un oxynitrure de silicium SiOₓN_{y} vérifiant 0≤y<x, formée sur la première couche, et comportant des atomes de bore.

Ainsi, une telle structure selon l'invention permet d'utiliser les excellentes propriétés de passivation de l'alumine tout en s'affranchissant des problèmes de stabilité thermique grâce à une telle deuxième couche, à base d'un oxynitrure de silicium, recouvrant la première couche à base d'alumine. La première couche présente une épaisseur strictement inférieure à 20 nm afin de ne pas former une barrière de diffusion pour les atomes de bore lorsque ceux-ci seront soumis à un traitement thermique compris entre 850°C et 1050°C. Ainsi, dans le cas de la fabrication de cellules photovoltaïques, en appliquant un tel traitement thermique, les atomes de bore pourront diffuser depuis la deuxième couche sous la surface du substrat de manière à former une région semi-conductrice dopée destinée à être en contact avec une électrode.

### Définitions

- Par « substrat », on entend le support mécanique, autoporté, notamment destiné à la fabrication d'une cellule photovoltaïque.
- Par « passiver/passivation », on entend la neutralisation de défauts électriquement actifs à la surface du substrat. En effet, la surface d'un substrat à base de silicium cristallin présente une densité de défauts (e.g. liaisons pendantes, impuretés, discontinuité du cristal etc.) pouvant entraîner des pertes non négligeables liées à la recombinaison en surface des porteurs dans le cas d'une application photovoltaïque.
- Par « cristallin », on entend la forme multicristalline ou la forme monocristalline du silicium, excluant donc le silicium amorphe.
- Par « à base de », on entend que le matériau correspondant est le matériau principal et majoritaire composant le substrat (ou la couche).
- Par « alumine », on entend l'oxyde d'aluminium de formule Al₂O₃ ou ses dérivés AlOₓ non stoechiométriques.

La structure selon l'invention peut comporter une ou plusieurs des caractéristiques suivantes.

Selon une caractéristique de l'invention, la première couche présente une épaisseur comprise entre 2 nm et 10 nm.

Ainsi, une telle gamme d'épaisseur donne les meilleurs résultats en termes de sur-dopage du silicium en impuretés dopantes de type p, se manifestant par une faible résistance électrique à la surface du substrat.

Selon une caractéristique de l'invention, la structure comporte une troisième couche, à base d'un nitrure de silicium SiN de préférence hydrogéné, formée sur la deuxième couche.

Ainsi, un avantage procuré est d'améliorer la passivation de la surface du substrat, et d'empêcher l'exo-diffusion des atomes de bore. En outre, une telle troisième couche en combinaison avec une couche d'alumine d'épaisseur comprise entre 2 nm et 10 nm donne les meilleurs résultats en termes de gain pour la tension en circuit ouvert (V_{OC}), de l'ordre de 10 mV, par rapport à un empilement SiON :B / SiN :H sans alumine.

Selon une caractéristique de l'invention, les atomes de bore présentent une proportion atomique dans la deuxième couche comprise entre 10% et 50%, de préférence comprise entre 10% et 30%.

Ainsi, de telles proportions atomiques permettent de former une région semi-conductrice dopée, sous la surface du substrat, destinée à être en contact avec une électrode, de bonne qualité, c'est-à-dire avec une concentration atomique surfacique supérieure à 10¹⁹ at.cm⁻³.

Selon une caractéristique de l'invention, la deuxième couche présente une épaisseur comprise entre 3 nm et 50 nm, de préférence comprise entre 20 nm et 35 nm.

Ainsi, un avantage procuré est d'allier une bonne qualité de passivation et une faible consommation de matière.

L'invention a également pour objet un procédé pour passiver une surface d'un substrat à base de silicium cristallin, comportant les étapes :
a) former une première couche, à base d'alumine, à la surface du substrat et présentant une épaisseur strictement inférieure à 20 nm ;
b) former une deuxième couche, à base d'un oxynitrure de silicium SiOₓN_{y} vérifiant 0≤y<x, sur la première couche, la deuxième couche comportant des atomes de bore ;
c) diffuser les atomes de bore depuis la deuxième couche sous la surface du substrat de manière à former une région semi-conductrice dopée destinée à être en contact avec une électrode.

Ainsi, un tel procédé selon l'invention permet de diffuser les atomes de bore depuis la deuxième couche sous la surface du substrat, de manière à former une région semi-conductrice dopée destinée à être en contact avec une électrode. La qualité de la passivation de la surface du substrat, obtenue en particulier grâce à la première couche, est suffisante pour autoriser la conservation des première et deuxième couches après l'étape c).

Le procédé selon l'invention peut comporter une ou plusieurs des caractéristiques suivantes.

Selon une caractéristique de l'invention, l'étape c) est exécutée en appliquant un recuit thermique, à une température de recuit comprise entre 850°C et 1050°C pendant une durée de recuit comprise entre 10 minutes et 1 heure.

Par « recuit thermique », on entend un traitement thermique comportant :
- une phase de montée graduelle en température (rampe de montée) jusqu'à atteindre une température dite température de recuit,
- une phase de maintien (plateau) à la température de recuit, pendant une durée dite durée de recuit,
- une phase de refroidissement.

Selon une caractéristique de l'invention, l'étape a) est exécutée de sorte que la première couche présente une épaisseur comprise entre 2 nm et 10 nm.

Ainsi, une telle gamme d'épaisseur donne les meilleurs résultats en termes de sur-dopage du silicium en impuretés dopantes de type p, se manifestant par une faible résistance électrique à la surface du substrat.

Selon une caractéristique de l'invention, le procédé comporte une étape b₁) consistant à former une troisième couche, à base d'un nitrure de silicium SiN de préférence hydrogéné, sur la deuxième couche ; l'étape b₁) étant exécutée avant l'étape c).

Ainsi, un avantage procuré est d'améliorer la passivation de la surface du substrat, et d'empêcher l'exo-diffusion des atomes de bore. En outre, une telle troisième couche en combinaison avec une couche d'alumine d'épaisseur comprise entre 2 nm et 10 nm donne les meilleurs résultats en termes de gain pour la tension en circuit ouvert (V_{OC}), de l'ordre de 10 mV.

Selon une caractéristique de l'invention, les première et deuxième couches sont conservées après l'étape c).

Ainsi, un avantage procuré est un gain de temps d'opération puisqu'il n'est pas nécessaire de retirer ces couches puis de former des couches de passivation dédiées.

L'invention a également pour objet une cellule photovoltaïque, comportant :
- un substrat à base de silicium cristallin, présentant une surface ;
- une première couche, à base d'alumine, formée à la surface du substrat, présentant une épaisseur strictement inférieure à 20 nm, et comprenant des atomes de bore dans une proportion résiduelle ;
- une deuxième couche, à base d'un oxynitrure de silicium SiOₓN_{y} vérifiant 0≤y<x, formée sur la première couche, et comportant des atomes de bore dans une proportion résiduelle ;
- une région semi-conductrice dopée, s'étendant sous la surface du substrat, comportant des atomes de bore, et destinée à être en contact avec une électrode.

Ainsi, une telle cellule photovoltaïque se distingue de l'état de la technique notamment par :
- une première couche à base d'alumine comprenant des atomes de bore dans une proportion résiduelle (notée AlOₓ : B) avec une quantité suffisante pour être détectée par ingénierie inverse,
- une deuxième couche, à base d'un oxynitrure de silicium SiOₓN_{y} vérifiant 0≤y<x, comportant des atomes de bore dans une proportion résiduelle qui n'ont pas diffusé sous la surface du substrat, et avec une quantité suffisante pour être détectée par ingénierie inverse.

### Brève description des dessins

D'autres caractéristiques et avantages apparaîtront dans l'exposé détaillé de différents modes de réalisation de l'invention, l'exposé étant assorti d'exemples et de référence aux dessins joints.

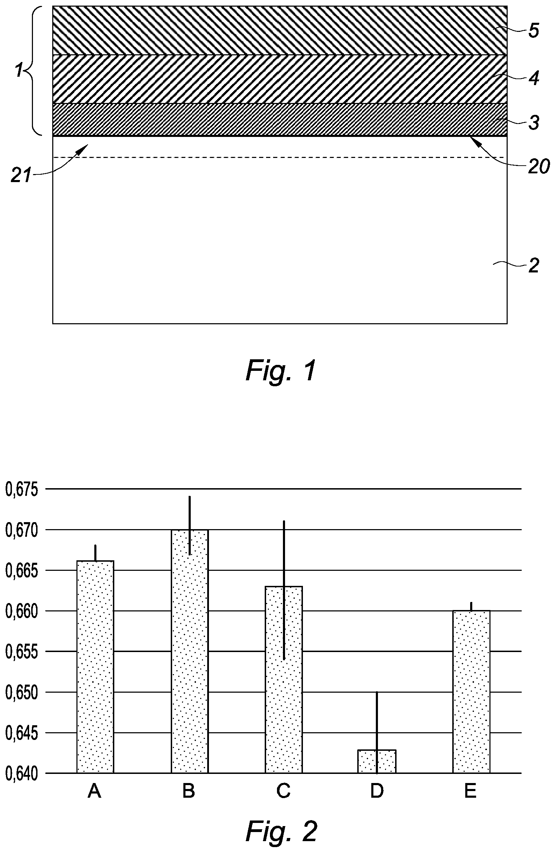

Figure 1 est une vue schématique en coupe d'une structure selon l'invention, formée sur une surface d'un substrat à base de silicium cristallin.
Figure 2 est un histogramme illustrant la tension en circuit ouvert (en V) en fonction de l'épaisseur de la première couche à base d'alumine pour une structure selon l'invention (colonnes A, B et C) munie d'une troisième couche à base de nitrure de silicium. Les colonnes A, B, C correspondent respectivement à 2 nm, 5 nm et 10 nm d'épaisseur de la première couche à base d'alumine. La colonne D correspond à une épaisseur de la première couche à base d'alumine de 20 nm. La colonne E est une référence correspondant à une couche unique à base d'un oxynitrure de silicium comportant des atomes de bore. Les traits représentent la marge d'erreur.

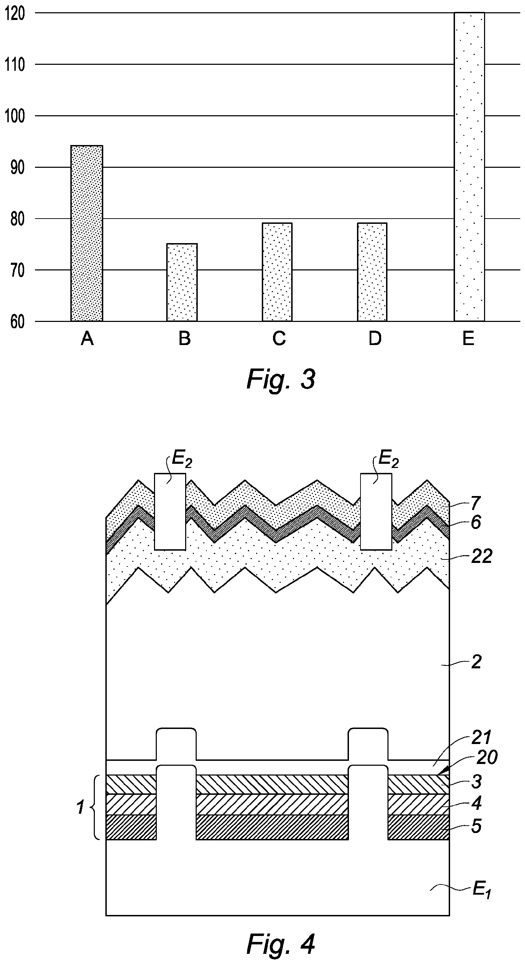

Figure 3 est un histogramme illustrant la résistance électrique (en ohms/□) à la surface d'un substrat muni d'une structure selon l'invention (colonnes B, C, D). Les colonnes B, C, D correspondent respectivement à 2 nm, 5 nm et 10 nm d'épaisseur de la première couche à base d'alumine. La colonne A est une référence correspondant à une couche unique à base d'un oxynitrure de silicium comportant des atomes de bore. La colonne E correspond à une épaisseur de la première couche à base d'alumine de 20 nm.

Figure 4 est une vue schématique en coupe d'une cellule photovoltaïque de type PERC (pour « *Passivated Emitter and Rear Cell*» en langue anglaise) munie d'une structure selon l'invention.

### Exposé détaillé des modes de réalisation

Les éléments identiques ou assurant la même fonction porteront les mêmes références pour les différents modes de réalisation, par souci de simplification.

Un objet de l'invention est une structure 1 pour passiver une surface 20 d'un substrat 2 à base de silicium cristallin, comportant :
- une première couche 3, à base d'alumine, destinée à être formée à la surface 20 du substrat 2, et présentant une épaisseur strictement inférieure à 20 nm ;
- une deuxième couche 4, à base d'un oxynitrure de silicium SiOₓN_{y} vérifiant 0≤y<x, formée sur la première couche 3, et comportant des atomes de bore.

### Première couche à base d'alumine

La première couche 3 présente avantageusement une épaisseur comprise entre 2 nm et 10 nm. Comme illustré à la figure 2 (colonnes A, B, C) et à la figure 3 (colonnes B, C, D), cette gamme d'épaisseurs permet :
- une augmentation signification de la tension en circuit ouvert (augmentation de l'ordre de 10 mV),
- une réduction significative de la résistance électrique à la surface 20 du substrat 2 (devient inférieure à 80 ohms/□), traduisant un sur-dopage du silicium en impuretés dopantes de type p.

### Deuxième couche à base d'un oxynitrure de silicium

Les atomes de bore présentent avantageusement une proportion atomique dans la deuxième couche 4 comprise entre 10% et 50%, de préférence comprise entre 10% et 30%. L'oxynitrure de silicium SiOₓN_{y} est de préférence hydrogéné. Lorsque y=0, l'oxynitrure de silicium est un oxyde de silicium.

La deuxième couche 4 présente avantageusement une épaisseur comprise entre 3 nm et 50 nm, de préférence comprise entre 20 nm et 35 nm.

### Troisième couche à base d'un nitrure de silicium

La structure 1 comporte avantageusement une troisième couche 5, à base d'un nitrure de silicium SiN de préférence hydrogéné, formée sur la deuxième couche 4. La troisième couche 5 présente préférentiellement une épaisseur comprise entre 20 nm et 200 nm. Une telle troisième couche 5 permet d'augmenter la tension en circuit ouvert.

### Procédé de passivation

Un autre objet de l'invention est un procédé pour passiver une surface 20 d'un substrat 2 à base de silicium cristallin, comportant les étapes :
a) former une première couche 3, à base d'alumine, à la surface 20 du substrat 2 et présentant une épaisseur strictement inférieure à 20 nm ;
b) former une deuxième couche 4, à base d'un oxynitrure de silicium SiOₓN_{y} vérifiant 0≤y<x, sur la première couche 3, la deuxième couche 4 comportant des atomes de bore ;
c) diffuser les atomes de bore depuis la deuxième couche 4 sous la surface 20 du substrat 2 de manière à former une région semi-conductrice dopée 21 destinée à être en contact avec une électrode E₁.

L'étape a) est avantageusement exécutée de sorte que la première couche 3 présente une épaisseur comprise entre 2 nm et 10 nm. L'étape a) est préférentiellement exécutée par ALD (Pour « *Atomic Layer Deposition* » en langue anglaise). La première couche 3 peut être déposée par ALD thermique ou plasma. La première couche 3 peut également être déposée par PECVD.

Lorsque la deuxième couche 4 est à base d'un oxynitrure de silicium hydrogéné, l'étape b) est préférentiellement exécutée par un dépôt chimique en phase vapeur du type PECVD (pour *Plasma-Enhanced Chemical Vapor Déposition* en langue anglaise) à partir de gaz réactifs comportant du silane SiH4 et du protoxyde d'azote N₂O. Les atomes de bore peuvent être incorporés à l'oxynitrure de silicium hydrogéné par une injection de diborane B₂H₆ avec les gaz réactifs.

Le procédé comporte avantageusement une étape b₁) consistant à former une troisième couche 5, à base d'un nitrure de silicium SiN de préférence hydrogéné, sur la deuxième couche 4 ; l'étape b₁) étant exécutée avant l'étape c).

Les première et deuxième couches 3,4 sont conservées après l'étape c). Le cas échéant, la troisième couche 5 est conservée après l'étape c).

### Recuit thermique

L'étape c) est avantageusement exécutée en appliquant un recuit thermique, à une température de recuit comprise entre 850°C et 1050°C pendant une durée de recuit comprise entre 10 minutes et 1 heure.

Le recuit thermique appliqué lors de l'étape c) présente avantageusement :
- une valeur de température de recuit comprise entre 880°C et 980°C, préférentiellement comprise entre 900°C et 960°C,
- une valeur de durée de recuit préférentiellement comprise entre 30 minutes et 1 heure.

L'étape c) est avantageusement exécutée sous une atmosphère oxydante. L'atmosphère oxydante comporte avantageusement du dioxygène et au moins un gaz neutre choisi parmi l'argon et l'azote. L'atmosphère oxydante est avantageusement constituée de dioxygène et d'au moins un gaz neutre choisi parmi l'argon et l'azote. L'atmosphère oxydante est avantageusement dépourvue d'agent dopant.

Le recuit thermique appliqué lors de l'étape c) est un recuit thermique global au sens où il est appliqué à l'ensemble comportant le substrat 2 et la structure 3, 4, 5. Il ne s'agit donc pas d'un recuit thermique localisé appliqué sur une partie dudit ensemble, par exemple à l'aide d'un laser. L'étape c) est préférentiellement exécutée dans un four.

A l'issue de l'étape c), les atomes de bore diffusent à une profondeur strictement inférieure à 1 µm à partir de la surface 20 du substrat 1. Après l'étape c), la région semi-conductrice dopée 21 présente préférentiellement, à la surface 20 du substrat, une concentration atomique surfacique supérieure à 10¹⁹ at./cm³, plus préférentiellement comprise entre 10¹⁹ at./cm³ et 3x10²⁰ at./cm³, afin de former une zone de contact électrique de bonne qualité. Après l'étape c), les atomes de bore présentent une proportion atomique dans la deuxième couche 4 comprise entre 1% et 10%, de préférence comprise entre 3% et 8%.

### Exemple d'application : cellule photovoltaïque de type PERC

Un autre objet de l'invention est une cellule photovoltaïque, comportant :
- un substrat 2 à base de silicium cristallin, présentant une surface 20 ;
- une première couche 3, à base d'alumine, formée à la surface 20 du substrat 2, présentant une épaisseur strictement inférieure à 20 nm, et comprenant des atomes de bore dans une proportion résiduelle ;
- une deuxième couche 4, à base d'un oxynitrure de silicium SiOₓN_{y} vérifiant 0≤y<x, formée sur la première couche 3, et comportant des atomes de bore dans une proportion résiduelle ;
- une région semi-conductrice dopée 21, s'étendant sous la surface 20 du substrat 2, comportant des atomes de bore, et destinée à être en contact avec une électrode E₁.

Une telle cellule photovoltaïque est obtenue à l'issue de l'étape c) du procédé de passivation.

Comme illustré à la figure 4, une structure 1 selon l'invention peut être formée en face arrière d'une cellule photovoltaïque de type PERC.

Le substrat 2 à base de silicium cristallin est dopé de type p. Le substrat 2 présente une première surface 20 (dite face arrière) et une seconde surface opposée (dite face avant). A titre d'exemple non limitatif, le substrat 2 peut présenter une épaisseur de l'ordre de 150 µm.

La cellule photovoltaïque comporte une structure 1 selon l'invention formée sur la première surface 20 du substrat. Il existe une étape consistant à mettre en contact la région semi-conductrice dopée 21 (dopage bore) avec des premières électrodes E₁. Cette étape comporte avantageusement une étape de métallisation, de préférence exécutée par sérigraphie. Les premières électrodes E₁ sont préférentiellement réalisées en aluminium.

La seconde surface du substrat 2 est destinée à être orientée vers un rayonnement solaire. La seconde surface du substrat 2 est avantageusement texturée afin de diminuer sa réflectivité. Ainsi, la seconde surface du substrat 2 comporte préférentiellement des motifs en pyramide inversée agencés pour créer une rugosité de surface. La texturation de la seconde surface du substrat 2 est préférentiellement exécutée par une attaque chimique à base d'hydroxyde de potassium KOH. La cellule photovoltaïque comporte une région semi-conductrice dopée 22 (dopage phosphore) s'étendant sous la seconde surface du substrat 2, de préférence formée par une implantation d'atomes de phosphore. La seconde surface du substrat 2 est préférentiellement recouverte d'un oxyde thermique 6 à base de SiO₂. L'oxyde thermique 6 est préférentiellement recouvert d'une couche 7 de nitrure de silicium. Il existe une étape consistant à mettre en contact la région semi-conductrice dopée 22 (dopage phosphore) avec des secondes électrodes E₂. Cette étape comporte avantageusement une étape de métallisation, de préférence exécutée par sérigraphie. Les secondes électrodes E₂ sont préférentiellement réalisées en argent.

L'invention ne se limite pas aux modes de réalisation exposés. L'homme du métier est mis à même de considérer leurs combinaisons techniquement opérantes, et de leur substituer des équivalents.

## Revendications

1. Structure (1) pour passiver une surface (20) d'un substrat (2) à base de silicium cristallin, comportant :
- une première couche (3), à base d'alumine, destinée à être formée à la surface (20) du substrat (2), et présentant une épaisseur strictement inférieure à 20 nm ;
- une deuxième couche (4), à base d'un oxynitrure de silicium SiOₓN_{y} vérifiant 0≤y<x, formée sur la première couche (3), et comportant des atomes de bore.

2. Structure (1) selon la revendication 1, dans laquelle la première couche (3) présente une épaisseur comprise entre 2 nm et 10 nm.

3. Structure (1) selon la revendication 1 ou 2, comportant une troisième couche (5), à base d'un nitrure de silicium SiN de préférence hydrogéné, formée sur la deuxième couche (4).

4. Structure (1) selon l'une des revendications 1 à 3, dans laquelle les atomes de bore présentent une proportion atomique dans la deuxième couche (4) comprise entre 10% et 50%, de préférence comprise entre 10% et 30%.

5. Structure (1) selon l'une des revendications 1 à 4, dans laquelle la deuxième couche (4) présente une épaisseur comprise entre 3 nm et 50 nm, de préférence comprise entre 20 nm et 35 nm.

6. Procédé pour passiver une surface (20) d'un substrat (2) à base de silicium cristallin, comportant les étapes :
a) former une première couche (3), à base d'alumine, à la surface (20) du substrat (2) et présentant une épaisseur strictement inférieure à 20 nm ;
b) former une deuxième couche (4), à base d'un oxynitrure de silicium SiOₓN_{y} vérifiant 0≤y<x, sur la première couche (3), la deuxième couche (4) comportant des atomes de bore ;
c) diffuser les atomes de bore depuis la deuxième couche (4) sous la surface (20) du substrat (2) de manière à former une région semi-conductrice dopée (21) destinée à être en contact avec une électrode (E₁).

7. Procédé selon la revendication 6, dans lequel l'étape c) est exécutée en appliquant un recuit thermique, à une température de recuit comprise entre 850°C et 1050°C pendant une durée de recuit comprise entre 10 minutes et 1 heure.

8. Procédé selon la revendication 6 ou 7, dans lequel l'étape a) est exécutée de sorte que la première couche (3) présente une épaisseur comprise entre 2 nm et 10 nm.

9. Procédé selon l'une des revendications 6 à 8, comportant une étape b₁) consistant à former une troisième couche (5), à base d'un nitrure de silicium SiN de préférence hydrogéné, sur la deuxième couche (4) ; l'étape b₁) étant exécutée avant l'étape c).

10. Procédé selon l'une des revendications 6 à 9, dans lequel les première et deuxième couches (3, 4) sont conservées après l'étape c).

11. Cellule photovoltaïque, comportant :
- un substrat (2) à base de silicium cristallin, présentant une surface (20) ;
- une première couche (3), à base d'alumine, formée à la surface (20) du substrat (2), présentant une épaisseur strictement inférieure à 20 nm, et comprenant des atomes de bore dans une proportion résiduelle ;
- une deuxième couche (4), à base d'un oxynitrure de silicium SiOₓN_{y} vérifiant 0≤y<x, formée sur la première couche (3), et comportant des atomes de bore dans une proportion résiduelle ;
- une région semi-conductrice dopée (21), s'étendant sous la surface (20) du substrat (2), comportant des atomes de bore, et destinée à être en contact avec une électrode (E₁).

## Patentansprüche

1. Struktur (1) zum Passivieren einer Oberfläche (20) eines Substrats (2) auf Basis von kristallinem Silicium, bestehend aus:
- einer ersten Schicht (3) auf Basis von Aluminiumoxid, die dazu bestimmt ist, auf der Oberfläche (20) des Substrats (2) gebildet zu werden, und die eine Stärke von unbedingt weniger als 20 nm aufweist,
- einer zweiten Schicht (4) auf Basis von Siliciumoxynitrid SiOₓN_{y}, für das gilt: 0 <y < x, die auf der ersten Schicht (3) gebildet ist und Bor-Atome enthält.

2. Struktur (1) nach Anspruch 1, bei der die erste Schicht (3) eine Stärke von 2 nm bis 10 nm aufweist.

3. Struktur (1) nach Anspruch 1 oder 2, die eine dritte Schicht (5) auf Basis eines vorzugsweise hydrierten Siliciumnitrid SiN enthält, die auf der zweiten Schicht (4) gebildet ist.

4. Struktur (1) nach einem der Ansprüche 1 bis 3, bei der die Bor-Atome in der zweiten Schicht (4) einen Atomgehalt von 10% bis 50%, vorzugsweise von 10% bis 30% aufweisen.

5. Struktur (1) nach einem der Ansprüche 1 bis 4, bei der die zweite Schicht (4) eine Stärke von 3 nm bis 50 nm, vorzugsweise von 20 nm bis 35 nm aufweist.

6. Verfahren zum Passivieren einer Oberfläche (20) eines Substrats (2) auf Basis von kristallinem Silicium, das die Verfahrensschritte aufweist:
a) Bilden einer ersten Schicht (3) auf Basis von Aluminiumoxid auf der Oberfläche (20) des Substrats (2), die eine Stärke von unbedingt weniger als 20 nm aufweist,
b) Bilden einer zweiten Schicht (4) auf Basis von Siliciumoxynitrid SiOₓN_{y}, für das gilt: 0 <y < x, auf der ersten Schicht (3), wobei die zweite Schicht (4) Bor-Atome enthält,
c) Diffundieren der Bor-Atome aus der zweiten Schicht (4) unter die Oberfläche (20) des Substrats (2), so dass ein dotierter halbleitender Bereich (21) gebildet wird, der dazu bestimmt ist, in Kontakt mit einer Elektrode (E₁) zu sein.

7. Verfahren nach Anspruch 6, bei dem der Verfahrensschritt c) ausgeführt wird, indem ein thermisches Glühen angewendet wird, und zwar bei einer Glüh-Temperatur von 850 °C bis 1050 °C über eine Glüh-Dauer von 10 Minuten bis 1 Stunde.

8. Verfahren nach Anspruch 6 oder 7, bei dem der Verfahrensschritt a) so ausgeführt wird, dass die erste Schicht (3) eine Stärke von 2 nm bis 10 nm aufweist.

9. Verfahren nach einem der Ansprüche 6 bis 8, das einen Verfahrensschritt b₁) enthält, der darin besteht, auf der zweiten Schicht (4) eine dritte Schicht (5) auf Basis eines vorzugsweise hydrierten Siliciumnitrid SiN zu bilden, wobei der Verfahrensschritt b₁) vor dem Verfahrensschritt c) durchgeführt wird.

10. Verfahren nach einem der Ansprüche 6 bis 9, bei dem die erste und die zweite Schicht (3, 4) nach dem Verfahrensschritt c) konserviert werden.

11. Fotoelement, bestehend aus:
- einem Substrat (2) auf Basis von kristallinem Silicium, das eine Oberfläche (20) aufweist,
- einer ersten Schicht (3) auf Basis von Aluminiumoxid, die auf der Oberfläche (20) des Substrats (2) gebildet ist und die eine Stärke von unbedingt weniger als 20 nm aufweist und Bor-Atome in einem Restgehalt enthält,
- einer zweiten Schicht (4) auf Basis eines Siliciumoxynitrid SiOₓN_{y}, für das gilt: 0 <y < x, die auf der ersten Schicht (3) gebildet ist und Bor-Atome in einem Restgehalt enthält,
- einem dotierten halbleitenden Bereich (21), der sich unter der Oberfläche (20) des Substrats (2) erstreckt, Bor-Atome enthält und dazu bestimmt ist, in Kontakt mit einer Elektrode (E₁) zu sein.

## Claims

1. Structure (1) for passivating a surface (20) of a substrate (2) made from crystalline silicon, comprising:
- a first layer (3), made from alumina, designed to be formed at the surface (20) of the substrate (2), and presenting a thickness strictly smaller than 20 nm,
- a second layer (4), made from silicon oxynitride SiOₓN_{y}, verifying 0≤y<x, formed on the first layer (3), and comprising boron atoms.

2. Structure (1) according to claim 1, wherein first layer (3) presents a thickness comprised between 2 nm and 10 nm.

3. Structure (1) according to claim 1 or 2, comprising a third layer (5), made from a silicon nitride SiN preferably a hydrogenated silicon nitride, formed on the second layer (4).

4. Structure (1) according to one of claims 1 to 3, wherein the boron atoms present an atomic proportion in the second layer (4) comprised between 10% and 50%, preferably comprised between 10% and 30%.

5. Structure (1) according to one of claims 1 to 4, wherein the second layer (4) presents a thickness comprised between 3 nm and 50 nm, preferably comprised between 20 nm and 35 nm.

6. Passivation process for passivating a surface (20) of a substrate (2) made from crystalline silicon, comprising the following steps:
a) forming a first layer (3), made from alumina, at the surface (20) of the substrate (2) and presenting a thickness strictly smaller than 20 nm;
b) forming a second layer (4), made from silicon oxynitride SiOₓN_{y}, verifying 0≤y<x, on the first layer (3), the second layer (4) comprising boron atoms;
c) diffusing the boron atoms from the second layer (4) under the surface (20) of the substrate (2) so as to form a doped semiconducting region (21) designed to be in contact with an electrode (E₁).

7. Process according to claim 6, wherein step c) is performed by applying a thermal anneal at an annealing temperature comprised between 850°C and 1050°C for an annealing time comprised between 10 minutes and 1 hour.

8. Process according to claim 6 or 7, wherein step a) is performed so that the first layer (3) presents a thickness comprised between 2 nm and 10 nm.

9. Process according to one of claims 6 to 8, comprising a step b₁) consisting in forming a third layer (5), made from a silicon nitride SiN preferably a hydrogenated silicon nitride SiN, on the second layer (4); step b₁) being performed before step c).

10. Process according to one of claims 6 to 9, wherein the first and second layers (3, 4) are kept after step c).

11. Photovoltaic cell comprising:
- a substrate (2) made from crystalline silicon, presenting a surface (20);
- a first layer (3), made from alumina, formed at the surface (20) of the substrate (2), presenting a thickness strictly smaller than 20 nm, and comprising boron atoms in a residual proportion;
- a second layer (4), made from silicon oxynitride SiOₓN_{y}, verifying 0≤y<x, formed on the first layer (3), and comprising boron atoms in a residual proportion;
- a doped semiconducting region (21), extending under the surface (20) of the substrate (2), comprising boron atoms and designed to be in contact with an electrode (E₁).
